# EUROPEAN PATENT SPECIFICATION

(11) **EP 3 051 601 B1**
(45) Date of publication and mention of the grant of the patent: **05.01.2022**
(21) Application number: 14849872.8
(22) Date of filing: 21.04.2014
(51) Int. Cl.: H01L 51/52, H01L 27/32, H01L 27/12

(54) **FLEXIBLE DISPLAY SUBSTRATE AND PREPARATION METHOD THEREFOR, AND FLEXIBLE DISPLAY DEVICE**
FLEXIBLES ANZEIGESUBSTRAT UND HERSTELLUNGSVERFAHREN DAFÜR SOWIE FLEXIBLE ANZEIGEVORRICHTUNG
SUBSTRAT DE DISPOSITIF D'AFFICHAGE FLEXIBLE ET SON PROCÉDÉ DE FABRICATION, ET DISPOSITIF D'AFFICHAGE FLEXIBLE

(30) Priority: 24.09.2013 CN 201310439383
(43) Date of publication of application: 03.08.2016
(73) Proprietor: BOE Technology Group Co., Ltd., Beijing 100015 (CN)
(72) Inventor: CHEN, Liqiang, Beijing 100176 (CN); GAO, Tao, Beijing 100176 (CN)
(74) Representative: Cohausz & Florack
(86) International application number: PCT/CN2014/075811
(87) International publication number: WO 2015/043169

(56) References cited:
- WO-A1-00/26973
- CN-A- 101 179 111
- CN-A- 101 785 086
- CN-A- 103 474 583
- CN-A- 103 500 745
- CN-U- 203 503 658
- CN-U- 203 503 661
- JP-A- 2012 212 522
- US-A1- 2003 178 937
- US-A1- 2011 204 361
- US-A1- 2013 112 984
- US-B1- 7 534 635

## Description

### FIELD OF THE INVENTION

The present invention belongs to the field of flexible display technology, and particularly relates to a flexible display substrate and a manufacturing method thereof, and a flexible display device.

### BACKGROUND OF THE INVENTION

With the development of technology, flexible display devices have been more and more widely applied. The flexible display devices include different types of organic light emitting diode display devices, electrophoretic display devices, and the like. Obviously, a base of a display substrate (for example, a flexible array substrate of a flexible organic light emitting diode display device) of the flexible display device must be a flexible base, and the flexible base is primarily made of organic materials such as polyimide, polyethylene terephthalate, and the like.

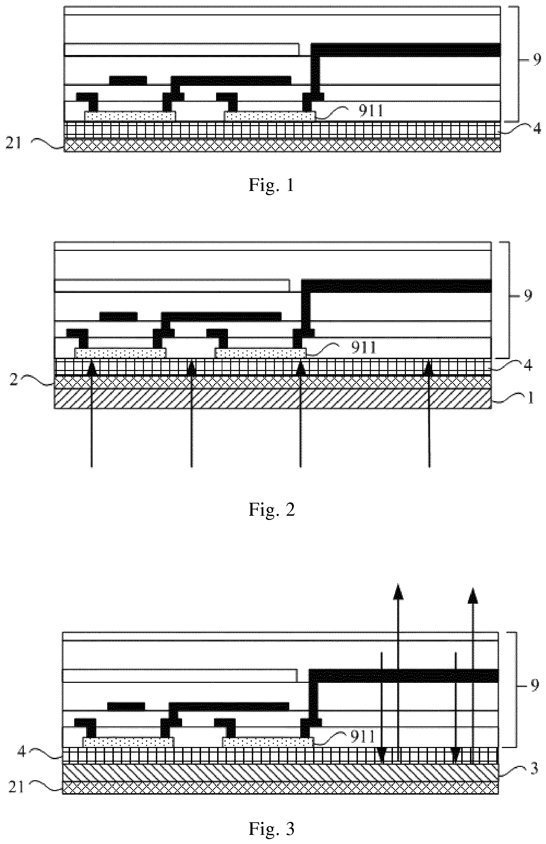

As the flexible base is susceptible to deformation, in the manufacturing process of the display substrate, the flexible base is rather difficult to be located, carried, and stored. For this reason, as shown in Figs.1 and 2, generally, a flexible material layer 2 is first formed on a glass base 1, and a buffer layer 4 and a display structure 9 are then formed successively (taking a flexible organic light emitting diode display device as an example, including a thin film transistor, a data line, a gate line, a capacitor, an anode, a cathode, an organic light emitting layer, a pixel defining layer, and the like, which are not labeled in drawings as they are known structures) on the flexible material layer 2. Then, the flexible material layer 2 is irradiated from a side of the glass base 1 with ultraviolet laser light, causing the adhesive force between the flexible material layer 2 and the glass base 1 to be reduced so that the flexible material layer is separated from the glass base 1 (i.e., laser lift-off) to form a separate flexible display substrate (at this time, the flexible material layer 2 becomes the flexible base 21).

Meanwhile, the flexible array substrate includes multiple display units arranged in an array form. These display units usually include thin film transistors, and low-temperature polysilicon thin film transistor is an important type of the thin film transistors, an active region 911 of which is constituted by polysilicon. A method for manufacturing the active region 911 includes: first, forming an amorphous silicon layer; then, irradiating the amorphous silicon layer from a side away from the glass base 1 with ultraviolet laser light (excimer laser light), allowing the amorphous silicon to be molten, nucleated, and grown by means of excimer laser annealing (ELA) to be transformed into polysilicon; and then, forming the active region 911 with the polysilicon layer.

The inventor has found that there are at least the following problems in the prior art.

First, in the process of laser lift-off, part of laser light may pass through the flexible material layer to be irradiated on the display structure, thereby having an influence on the performance of the display structure; for example, if the laser light is irradiated on the active region of the thin film transistor (particularly metal oxide thin film transistor), defects such as threshold voltage shift and the like will be caused.

Second, for the array substrate having low-temperature polysilicon thin film transistors, in its laser annealing process, the laser light may pass through the amorphous silicon layer to be irradiated on the flexible material layer, thereby degrading the performance of the flexible material layer, for example causing the flexible material layer to be carbonized or separated from an adjacent layer (for example, a buffer layer), and the like. A flexible display substrate comprising a flexible base and a reflective layer on the flexible base is known from US7534635 B1 or WO00/26973 A1 .Portion of a metal film and a resist film which cover an alignment mark on a silicon wafer are removed in US5405810 A.

### SUMMARY OF THE INVENTION

In view of the problem that display structures in the existing flexible display substrates are likely to be damaged at the time of laser lift-off, the present invention provides a flexible display substrate and a manufacturing method thereof, and a flexible display device that can protect the display structures against damage in laser lift-off.

A technical solution employed to solve the technical problem of the present invention is a flexible display substrate, including a flexible base and a display structure, and a reflective layer provided between the flexible base and the display structure, wherein the reflective layer is provided with an opening at a position corresponding to an alignment mark.

The "display structure" refers to all structures formed above the reflective layer and used for displaying. According to the types of flexible display substrates, the display structure may include: a thin film transistor, a gate line, a gate insulating layer, a data line, a planarizing layer (PLN), a passivation layer (PVX), a capacitor, an anode, a cathode, an organic light emitting layer, a pixel defining layer (PDL), a color filter film, and the like.

A technical solution employed to solve the technical problem of the present invention is a manufacturing method of a flexible display substrate, including:
forming a flexible material layer on a base;
forming a reflective layer on the flexible material layer;
forming a display structure; and
separating the flexible material layer from the base by means of laser lift-off to obtain the flexible display substrate, wherein between the step of forming the reflective layer and the step of forming a display structure, the method further includes: forming an opening in the reflective layer at a position corresponding to an alignment mark.

Preferred embodiment are defined in the dependent claims.

At the same time, the reflective layer is preferably a metal material. The metal material layer always has good water and oxygen isolation performance, and it may thus prevent moisture, oxygen, and the like from contacting the display structure, to protect (similar to packaging) the display structure.

In addition, for the flexible array substrate having a low-temperature polysilicon thin film transistor, during the laser annealing, the laser light passing through the amorphous layer also may be reflected back by the reflective layer, to protect the flexible material layer against damage.

The present invention is applicable to flexible display devices, particularly to flexible top-emitting type organic light emitting diode display devices and flexible array substrates with low-temperature polysilicon thin film transistors.

### BRIEF DESCRIPTION OF THE DRAWINGS

Fig. 1 is a sectional structure diagram of an existing flexible display substrate;
Fig. 2 is a sectional structure diagram of an existing flexible display substrate during laser lift-off in the manufacturing process;
Fig. 3 is a sectional structure diagram of a flexible display substrate according to Embodiment 1;
Fig. 4 is a graph of absorption spectrum and reflection spectrum of aluminum;
Fig. 5 is a top structure diagram of the flexible display substrate with an alignment opening provided on the reflective layer in the manufacturing process according to the Embodiment of the present invention;
Fig. 6 is a sectional structure diagram of the flexible display substrate during laser annealing in the manufacturing process according to Embodiment 1 of the present invention;
Fig. 7 is a sectional structure diagram of a flexible display substrate during laser lift-off in the manufacturing process according to Embodiment 1 of the present invention; in which, reference numerals:
   1. glass base;
   2. flexible material layer;
   21. flexible base;
   3. reflective layer;
   31. opening;
   4. buffer layer;
   8. alignment mark;
   9. display structure;
   91. amorphous silicon layer;
   911. active region.

### DESCRIPTION OF THE PREFERRED EMBODIMENT

In order to make a person skilled in the art better understand technical solutions of a flexible display substrate, comprising a flexible base and a display structure, further comprising a reflective layer between the flexible base and the display structure, the flexible display structure will be further described in details below in conjunction with the accompanying drawings and specific implementation.

### Embodiment 1:

As shown in Figs. 3 to 7, this embodiment provides a flexible display substrate, including:
a flexible base 21;
a reflective layer 3 provided on the flexible base 21; and
a display structure 9 provided above the reflective layer 3;

The "display structure 9" refers to all structures formed above the reflective layer 3 and used for displaying. According to types of flexible display substrates, the display structure 9 may include: a thin film transistor, a gate line, a gate insulating layer, a data line, a planarizing layer (PLN), a passivation layer (PVX), a capacitor, an anode, a cathode, an organic light emitting layer, a pixel defining layer (PDL), a color filter film, and the like.

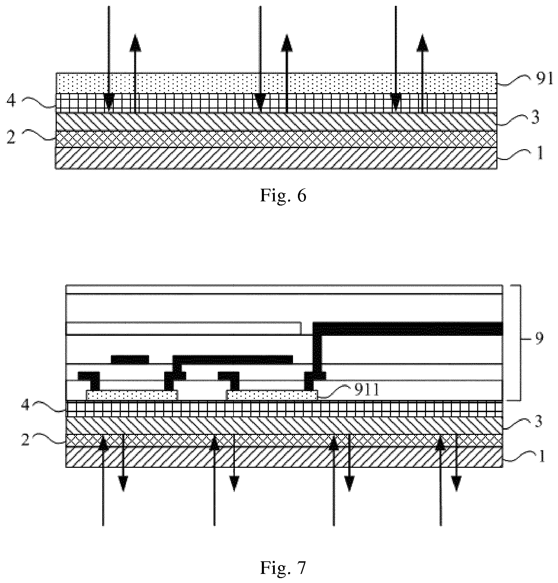

In the flexible display substrate of this embodiment, the reflective layer 3 is provided between the flexible base 21 and the display structure 9. Thus, as shown in Fig. 7, in the laser lift-off, the laser light passing through the flexible material layer 2 may be reflected back by the reflective layer 3, to prevent laser light from irradiating on the display structure 9 including the thin film transistor and the like, thereby preventing the performance of the display structure 9 from being influenced. Meanwhile, metal reflective layer always has good water and oxygen isolation performance, and it may thus prevent moisture, oxygen, and the like from contacting the display structure 9, to play role in protecting the display structure 9.

Preferably, this embodiment takes the array substrate of the flexible top-emitting type organic light emitting diode display device as an example of the flexible display substrate. That is, the display structure in the flexible display substrate includes multiple display units arranged in an array form, and the display units are top-emitting type organic light emitting diode display units which include a driving circuit (a switch thin film transistor, a driving thin film transistor, a capacitor and the like), a gate line, a data line, a cathode, an anode, an organic light emitting layer, a pixel defining layer, and the like, and which emit light from a side away from the flexible base 21.

As shown in Fig. 3, the reflective layer 3 may reflect back light emitted by the organic light emitting layer and irradiated towards the flexible base 21, thus improving the light extraction efficiency of the flexible display substrate. In addition, the flexible display substrate is preferably a flexible array substrate including multiple display units arranged in an array form, and each display unit usually includes a thin film transistor, an active region 911 of which (particularly metal oxide thin film transistor) is a display structure 9 which is most likely to be influenced in the laser lift-off process. Therefore, the reflective layer 3 may protect the array substrate to the largest extent.

Preferably, for the flexible array substrate (not limited to application in organic light emitting diode display devices), a low-temperature polysilicon thin film transistor is preferably used. That is, the active region 911 of the thin film transistor is made of a low-temperature polysilicon material.

For the low-temperature polysilicon thin film transistor, the active region 911 made of polysilicon is formed by: first, forming an amorphous silicon layer 91, and transforming the amorphous silicon layer 91 into a polysilicon layer by laser annealing. During the laser annealing, part of laser light may pass through the amorphous silicon layer 91 to damage the flexible base 21. Here, the reflective layer 3 may also reflect the laser light back, to protect the flexible base 21 against damage during the laser annealing.

Of course, it should be understood that the thin film transistor in the flexible display substrate is not limited to the low-temperature polysilicon thin film transistor.

Preferably, the flexible base 21 is made of organic flexible material, more preferably, polyimide or polyethylene terephthalate, because the flexible base 21 made of an organic flexible material is more frequently used due to its mature technology. In addition, a flexible base 21 made of organic flexible material is preferred, because the organic flexible material is more likely to be damaged by laser light. Of course, a flexible base 21 made of inorganic materials such as stainless steel is also feasible.

Preferably, the reflective layer 3 is a metal reflective layer, and a buffer layer 4 is also provided between the reflective layer 3 and the display structure 9.

Metal, as a most common reflective material, is low in cost and is not likely to be damaged by laser light; and the process of evaporating metal to form a thin film is very mature, therefore, the reflective layer 3 is preferably made of a metal material.

Furthermore, as the metal material is conductive, a buffer layer 4 is required to be further formed on the metal material when the metal material is used for manufacturing the reflective layer 3, to prevent the metal reflective layer from directly conducting the display structure 9 including the active region 911, the gate line, the data line and the like.

The buffer layer 4 may be made of known inorganic materials such as silicon nitride (SiNx) and silicon oxide (SiO₂) and may have a thickness of preferably 250 nm to 400 nm. In addition to insulating, the buffer layer 4 may also reduce the surface roughness, and improve the bonding between the display structure 9 and the flexible base 21, and the like. A buffer layer 4 exists in the conventional display substrate, and thus will not be described in detail here.

Of course, it should be understood that the reflective layer 3 may also be made of other non-conductive materials (for example, a reflective layer made of a polymer material). In this case, the buffer layer 4 may be omitted.

Further preferably, the metal reflective layer is made of aluminum.

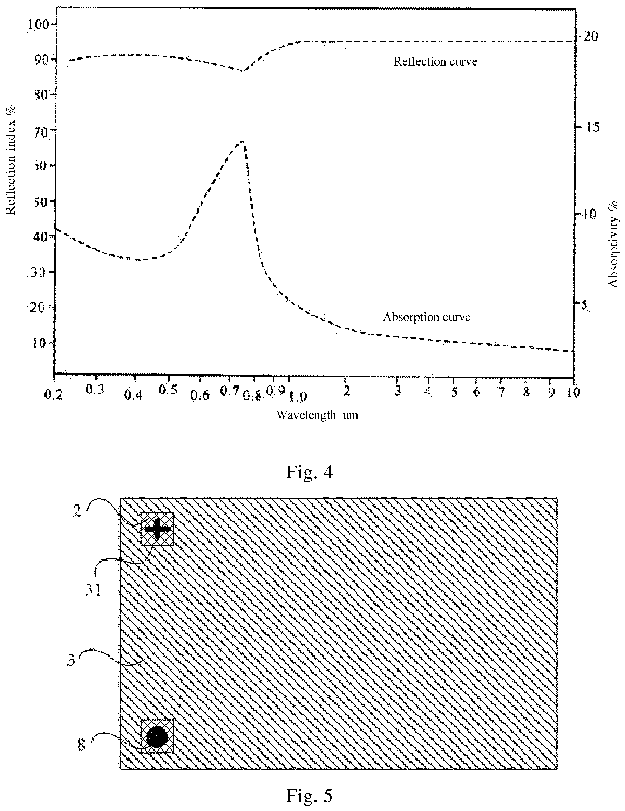

Ultraviolet laser light having a wavelength of 308 nm is usually used in processes such as laser lift-off, laser annealing. Among the frequently used metal materials, aluminum has a high reflection index to light within the wavelength range of the ultraviolet light (its reflection/absorption curve is as shown in Fig. 4). Therefore, the reflective layer 3 may be made of aluminum preferably. It can be seen from Fig. 4 that aluminum material has a high reflection index (corresponding to the reflection index coordinates on the left side) and a high absorptivity (corresponding to the absorptivity coordinates on the right side) to light within the wavelength range (4 nm to 380 nm) of the ultraviolet light, so that ultraviolet rays may be prevented from passing through to the largest extent.

Of course, it should be understood that it is possible to make the metal reflective layer from other metals or alloys having a high reflection index to the ultraviolet range (ultraviolet light), for example, rhodium (Rh) also has a high reflection index to the ultraviolet range. Furthermore, the use of conventional metals (having a low reflection index to the ultraviolet range) such as copper and silver is possible.

Further preferably, the thickness of the metal reflective layer (aluminum reflective layer as an example) is 150 nm to 300 nm.

Apparently, the larger the thickness of the reflective layer 3 is, the better the reflective effect of the reflective layer 3 is. However, a too large thickness of the reflective layer 3 will cause reduced flexibility, reduced adhesive force and increased cost and the like. It has been proved by studies that, for the metal reflective layer, the above thickness range not only may result in good reflective effect but also will not produce adverse influence on other performances.

As shown in Fig. 5, the reflective layer 3 of the inventive flexible display substrate is provided with an opening 31 at a position corresponding to an alignment mark 8.

In the manufacturing process of the display substrate, the patterning process, IC bonding process and other steps require accurate alignment. A common alignment method is to perform alignment by providing an alignment mark 8 in an abutment supporting the glass substrate 1 so that this alignment mark 8 may be seen through the flexible material layer 2 and the like (because these layers are transparent). Whereas in this inventive embodiment, the reflective layer 3 is opaque and will thus block the alignment mark 8 so that it cannot be seen. Therefore, it is necessary to provide an opening 31 at a position in the reflective layer 3 corresponding to the alignment mark 8.

This inventive embodiment further provides a flexible display device including the above flexible display substrate as shown in Figure 5.

The flexible display device of this embodiment further ma comprise in addition to the above flexible display substrate, other structures such a packing substrate, the flexible display device is preferably a flexible top-emitting type organic light emitting diode display device. Of course, other types of flexible display devices are possible.

This embodiment further provides a manufacturing method of the above flexible display substrate, including the following steps.

S01: A base is prepared.

This base may be a conventional hard base, like a glass base 1.

S02: A flexible material layer 2 is formed on the base.

This flexible material layer 2 is preferably an organic flexible material layer 2, for example, a layer made of polyimide or polyethylene terephthalate.

This flexible material layer 2 may be manufactured by conventional methods such as coating, and in the subsequent laser lift-off step, the flexible material layer 2 will be separated from the glass base 1 to become the flexible base 21 of the flexible display substrate.

S03: A reflective layer 3 is formed on the flexible material layer 2.

Preferably, this reflective layer 3 is a metal reflective layer, and further preferably an aluminum reflective layer.

For the metal reflective layer, it is preferably manufactured by a vacuum evaporation method.

Specifically, as for the aluminum reflective layer, parameters of its vacuum evaporation process are preferably as follows: the evaporation rate is greater than or equal to 40 nm/s, the evaporation air pressure is less than or equal to 1.3×10⁻⁴ Pa, and the thickness to be evaporated is between 150 nm and 300 nm.

Since aluminum is likely to be oxidized during the evaporation to form aluminum oxide, a high evaporation speed and a low evaporation air pressure are preferred to reduce the oxidization.

Of course, for a reflective layer 3 made of other materials, it may be manufactured by other methods such as affixing.

S04: In the inventive manufacturing method, as shown in Fig. 5, an opening 31 is formed at a position of the reflective layer 3 corresponding to an alignment mark 8.

That is to say, the opening 31 is formed at the position of the reflective layer 3 corresponding to the alignment mark 8 (which may be formed in an abutment forming the glass base 1) by a patterning process, to expose the alignment mark 8, for the purpose of alignment in the subsequent steps.

S05: Preferably, a buffer layer 4 is formed on the metal reflective layer.

When the reflective layer 3 is a metal reflective layer, to prevent the reflective layer from conducting all parts in the display structure 9, it is necessary to form the buffer layer 4 which has a function of insulating on the reflective layer 3.

The buffer layer 4 is usually an inorganic layer made of known materials such as silicon nitride and silicon oxide (for example, made of mixed materials of silicon nitride and silicon oxide), and has a thickness of 250 nm to 400 nm. The buffer layer may be manufactured by plasma enhanced chemical vapor deposition (PECVD), and the reaction gas used in the deposition may be a mixed gas of SiH₄, NH₃ and N₂, or a mixed gas of SiH₄, NO₂ and N₂.

The material, thickness, manufacturing process and the like of the buffer layer 4 will not be described here since they are well known.

Of course, if the reflective layer 3 is made of a non-conductive material, the step of forming the buffer layer 4 may be omitted (of course, it may be formed to improve the bonding performance of the display structure 9).

S06: Preferably, an amorphous silicon layer 91 is formed.

The amorphous silicon layer 91 may be formed by chemical vapor deposition and may have a thickness of preferably 40 nm to 60 nm.

S07: Preferably, as shown in Fig. 6, the amorphous silicon layer 91 is transformed to a polysilicon layer by laser annealing (excimer laser annealing).

The laser light used in the laser annealing is preferably ultraviolet laser light, and most preferably has a wavelength of 308 nm.

As shown in Fig. 6, in the laser annealing process, due to the presence of the reflective layer 3, laser light passing through the amorphous silicon layer 91 will be reflected back by the reflective layer 3, instead of being irradiated on the flexible material layer 2, so that no damage is produced to the flexible material layer 2.

The active region 911 of the thin film transistor manufactured according to the method of the embodiment is close to the buffer layer 4. That is, such a thin film transistor belongs to a "top-gate type thin film transistor". However, apparently, bottom-gate type thin film transistors are also applicable to the present invention, the difference is that, during manufacturing the bottom-gate type thin film transistor, it is necessary to form structures such as the gate/gate line and the gate insulating layer first and then manufacture the amorphous silicon layer 91.

It should be understood that, it is possible to use other types of thin film transistors such as a metal oxide thin film transistor in the flexible array substrate manufactured according to the method of the embodiment. In this case, it is only required to form the metal oxide layer, and no laser annealing is required.

S08: Other parts of the display structure 9 are formed continuously.

Specifically, this step may include: forming an active region 911 from a polysilicon layer by a patterning process, and continuously forming a gate insulating layer, a gate/gate line, a source/a drain, a passivation layer, a data line, a planarizing layer, an anode, a pixel defining layer, an organic light emitting layer, a cathode, a color filter film and the like.

Apparently, the specific type, structure and position of the display structure 9 formed in this step, and the processes, order and parameters and the like used for forming the various display structure 9 are different according to types of the flexible display substrates. Those belong to the known technologies and will not be described in detail here.

S09: As shown in Fig. 7, the flexible material layer 2 is laser lifted-off to obtain the flexible display substrate.

That is to say, the flexible material layer 2 is irradiated with ultraviolet laser light (preferably, with a wavelength of 308 nm) from one side of the glass base 1, so that the flexible material layer 2 and the display structure on the same fall off the glass base 1 to form a separated flexible display substrate. In this case, the flexible material layer 2 is the flexible base 21 of the flexible display substrate.

As shown in Fig. 7, in the laser lift-off process, due to the presence of the reflective layer 3, laser light passing through the flexible material layer 2 will be reflected back by the reflective layer 3, instead of being irradiated on the display structure 9 including a thin film transistor and the like, so that no damage is produced to the display structure 9.

In the flexible display substrate manufactured according to the method of this embodiment, the metal reflective layer has good oxygen and water isolation performance and thus may protect the display structure 9. Meanwhile, if what is manufactured is an array substrate of a flexible top-emitting type organic light emitting diode display device, as shown in Fig. 3, the reflective layer 3 may reflect light irradiated towards the flexible base 21 back, thus improving the light extraction efficiency.

## Claims

1. A flexible display substrate, comprising a flexible base and a display structure, wherein the flexible display substrate further comprises:
a reflective layer provided between the flexible base and the display structure, **characterized in that**
the reflective layer is provided with an opening at a position corresponding to an alignment mark.

2. The flexible display substrate according to claim 1, wherein
the reflective layer is a metal reflective layer; and
a buffer layer is further provided between the reflective layer and the display structure.

3. The flexible display substrate according to claim 2, wherein
the metal reflective layer is made of aluminum.

4. The flexible display substrate according to claim 3, wherein
the thickness of the metal reflective layer is between 150 nm and 300 nm.

5. The flexible display substrate according to any one of claims 1 to 4, wherein
the flexible base is made of an organic flexible material.

6. The flexible display substrate according to any one of claims 1 to 4, wherein
the display structure includes a plurality of display units arranged in an array form; and
the display unit includes a low-temperature polysilicon thin film transistor.

7. The flexible display substrate according to any one of claims 1 to 4, wherein
the display structure includes a plurality of display units arranged in an array form; and
the display units are top-emitting type organic light emitting diode display units.

8. A flexible display device, comprising:
the flexible display substrate according to any one of claims 1 to 7.

9. A manufacturing method of a flexible display substrate, comprising:
forming a flexible material layer on a base;
forming a reflective layer on the flexible material layer;
forming a display structure above the reflective layer; and
separating the flexible material layer from the base by means of laser lift-off to obtain the flexible display substrate,
**characterized in that** between the step of forming the reflective layer and the step of forming a display structure, the method further comprises:
forming an opening in the reflective layer at a position corresponding to an alignment mark.

10. The manufacturing method of a flexible display substrate according to claim 9, wherein
the reflective layer is a metal reflective layer; and
between the step of forming the metal reflective layer and the step of forming a display structure, the method further comprises: forming a buffer layer on the metal reflective layer.

11. The manufacturing method of a flexible display substrate according to claim 10, wherein
the metal reflective layer is made of aluminum, and formed by a vacuum evaporating process; and parameters for the vacuum evaporating process are as follows: the evaporation rate is greater than or equal to 40 nm/s, the evaporation air pressure is less than or equal to 1.3×10⁻⁴ Pa, and the thickness to be evaporated is between 150 nm and 300 nm.

12. The manufacturing method of a flexible display substrate according to claim 9, wherein the display structure includes a plurality of display units arranged in an array form, and the display unit includes a low-temperature polysilicon thin film transistor;
the step of forming a display structure comprises:
forming an amorphous silicon layer; and
transforming the amorphous silicon layer into a polysilicon layer by laser annealing.

## Patentansprüche

1. Flexibles Anzeigesubstrat, eine flexible Basis und eine Anzeigestruktur aufweisend, wobei das flexible Anzeigesubstrat ferner aufweist:
eine reflektierende Schicht, die zwischen der flexiblen Basis und der Anzeigestruktur vorgesehen ist, **dadurch gekennzeichnet, dass**
die reflektierende Schicht mit einer Öffnung an einer Position versehen ist, die einer Ausrichtungsmarkierung entspricht.

2. Flexibles Anzeigesubstrat nach Anspruch 1, wobei
die reflektierende Schicht eine metallische reflektierende Schicht ist; und
zwischen der reflektierenden Schicht und der Anzeigestruktur ferner eine Pufferschicht vorgesehen ist.

3. Flexibles Anzeigesubstrat nach Anspruch 2, wobei
die metallische reflektierende Schicht aus Aluminium hergestellt ist.

4. Flexibles Anzeigesubstrat nach Anspruch 3, wobei
die Dicke der metallischen reflektierende Schicht zwischen 150 nm und 300 nm liegt.

5. Flexibles Anzeigesubstrat nach einem der Ansprüche 1 bis 4, wobei
die flexible Basis aus einem organischen flexiblen Material hergestellt ist.

6. Flexibles Anzeigesubstrat nach einem der Ansprüche 1 bis 4, wobei
die Anzeigestruktur mehrere Anzeigeeinheiten enthält, die in einer Array-Form angeordnet sind; und
die Anzeigeeinheit einen Niedertemperatur-Polysilizium-Dünnschichttransistor enthält.

7. Flexibles Anzeigesubstrat nach einem der Ansprüche 1 bis 4, wobei
die Anzeigestruktur mehrere Anzeigeeinheiten enthält, die in einer Array-Form angeordnet sind; und
die Anzeigeeinheiten organische Leuchtdioden-Anzeigeeinheiten von dem oben emittierenden Typ sind.

8. Flexible Anzeigevorrichtung, aufweisend:
das flexible Anzeigesubstrat nach einem der Ansprüche 1 bis 7.

9. Herstellungsverfahren für ein flexibles Anzeigesubstrat, umfassend:
Bilden einer flexiblen Materialschicht auf einer Basis;
Bilden einer reflektierenden Schicht auf der flexiblen Materialschicht;
Bilden einer Anzeigestruktur oberhalb der reflektierenden Schicht; und
Trennen der flexiblen Materialschicht von der Basis mittels Laserabhebung, um das flexible Anzeigesubstrat zu erhalten,
**dadurch gekennzeichnet, dass**
das Verfahren zwischen dem Schritt des Bildens der reflektierenden Schicht und dem Schritt des Bildens einer Anzeigestruktur ferner umfasst:
Bilden einer Öffnung in der reflektierenden Schicht an einer Position, die einer Ausrichtungsmarkierung entspricht.

10. Herstellungsverfahren für ein flexibles Anzeigesubstrat nach Anspruch 9, wobei
die reflektierende Schicht eine metallische reflektierende Schicht ist; und
zwischen dem Schritt des Bildens der metallischen reflektierenden Schicht und dem Schritt des Bildens einer Anzeigestruktur das Verfahren ferner umfasst: Bilden einer Pufferschicht auf der metallischen reflektierende Schicht.

11. Herstellungsverfahren für ein flexibles Anzeigesubstrat nach Anspruch 10, wobei
die metallische reflektierende Schicht aus Aluminium hergestellt ist und durch einen Vakuumverdampfungsprozess gebildet wird; und die Parameter für den Vakuumverdampfungsprozess wie folgt sind: die Verdampfungsrate ist größer als oder gleich 40 nm/s, der Verdampfungsluftdruck ist kleiner als oder gleich 1,3•10⁻⁴ Pa und die zu verdampfende Dicke zwischen 150 nm und 300 nm beträgt.

12. Herstellungsverfahren für ein flexibles Anzeigesubstrat nach Anspruch 9, wobei die Anzeigestruktur mehrere Anzeigeeinheiten enthält, die in einer Array-Form angeordnet sind, und die Anzeigeeinheit einen Niedertemperatur-Polysilizium-Dünnschichttransistor enthält;
der Schritt des Bildens einer Anzeigestruktur aufweist:
Bilden einer amorphen Siliziumschicht; und
Umwandeln der amorphen Siliziumschicht in eine Polysiliziumschicht durch Lasertempern.

## Revendications

1. Substrat d'affichage flexible, comprenant une base flexible et une structure d'affichage, dans lequel le substrat d'affichage flexible comprend en outre :
une couche réfléchissante prévue entre la base flexible et la structure d'affichage, **caractérisé en ce que** la couche réfléchissante est munie d'une ouverture à une position correspondant à une marque d'alignement.

2. Substrat d'affichage flexible selon la revendication 1, dans lequel la couche réfléchissante est une couche réfléchissante métallique ; et une couche tampon est en outre prévue entre la couche réfléchissante et la structure d'affichage.

3. Substrat d'affichage flexible selon la revendication 2, dans lequel la couche métallique réfléchissante est en aluminium.

4. Substrat d'affichage flexible selon la revendication 3, dans lequel l'épaisseur de la couche métallique réfléchissante est comprise entre 150 nm et 300 nm.

5. Substrat d'affichage flexible selon l'une quelconque des revendications 1 à 4, dans lequel la base souple est réalisée en un matériau organique flexible.

6. Substrat d'affichage flexible selon l'une quelconque des revendications 1 à 4, dans lequel la structure d'affichage comprend une pluralité d'unités d'affichage agencées sous la forme d'un réseau ; et l'unité d'affichage comprend un transistor à couche mince de polysilicium basse température.

7. Substrat d'affichage flexible selon l'une quelconque des revendications 1 à 4, dans lequel la structure d'affichage comprend une pluralité d'unités d'affichage agencées sous la forme d'un réseau ; et les unités d'affichage sont des unités d'affichage à diodes électroluminescentes organiques du type à émission par le haut.

8. Dispositif d'affichage flexible, comprenant :
le substrat d'affichage flexible selon l'une quelconque des revendications 1 à 7.

9. Procédé de fabrication d'un substrat d'affichage flexible, comprenant les étapes consistant à :
former une couche de matériau flexible sur une base ;
former une couche réfléchissante sur la couche de matériau flexible ;
former une structure d'affichage au-dessus de la couche réfléchissante ; et
séparer la couche de matériau flexible de la base au moyen d'un décollement laser pour obtenir le substrat d'affichage flexible, **caractérisé en ce qu'**entre l'étape de formation de la couche réfléchissante et l'étape de formation d'une structure d'affichage, le procédé comprend en outre l'étape consistant à :
former une ouverture dans la couche réfléchissante à une position correspondant à une marque d'alignement.

10. Procédé de fabrication d'un Substrat d'affichage flexible selon la revendication 9, dans lequel
la couche réfléchissante est une couche métallique réfléchissante ; et
entre l'étape de formation de la couche réfléchissante métallique et l'étape de formation d'une structure d'affichage, le procédé comprend en outre : la formation d'une couche tampon sur la couche réfléchissante métallique.

11. Procédé de fabrication d'un substrat d'affichage flexible selon la revendication 10, dans lequel la couche métallique réfléchissante est en aluminium, et formée par un procédé d'évaporation sous vide ; et les paramètres du processus d'évaporation sous vide sont les suivants : la vitesse d'évaporation est supérieure ou égale à 40 nm/s, la pression d'air d'évaporation est inférieure ou égale à 1,3 × 10⁻⁴Pa, et l'épaisseur à évaporer est comprise entre 150 nm et 300 nm.

12. Procédé de fabrication d'un substrat d'affichage flexible selon la revendication 9, dans lequel la structure d'affichage comprend une pluralité d'unités d'affichage agencées sous la forme d'un réseau, et l'unité d'affichage comprend un transistor à couche mince de polysilicium basse température ; l'étape de formation d'une structure d'affichage comprend les étapes consistant à :
former une couche de silicium amorphe ; et
transformer la couche de silicium amorphe en une couche de polysilicium par recuit laser.
